# FASCICULE DE BREVET EUROPEEN

(11) **EP 1 759 566 B1**
(45) Date de publication et mention de la délivrance du brevet: **12.03.2008**
(21) Numéro de dépôt: 05747966.9
(22) Date de dépôt: 30.05.2005
(51) Int. Cl.: H05K 7/14

(54) **APPAREIL DE COMMANDE MOTEUR**
MOTORSTEUERVORRICHTUNG
MOTOR CONTROL APPARATUS

(30) Priorité: 16.06.2004 FR 0406505
(43) Date de publication de la demande: 07.03.2007
(73) Titulaire: Schneider Toshiba Inverter Europe, 27120 Pacy sur Eure (FR)
(72) Inventeur: BARREAU, Jérôme, F-95800 Courdimanche (FR)
(74) Mandataire: Dufresne, Thierry
(86) Numéro de dépôt international: PCT/EP2005/052441
(87) Numéro de publication internationale: WO 2005/125294

(56) Documents cités:
- EP-A- 0 290 617
- FR-A- 2 235 572
- US-A- 4 908 738
- US-B1- 6 587 056

## Description

La présente invention se rapporte à un appareil électronique destiné à la commande et au contrôle de moteurs électriques. Plus particulièrement, l'invention concerne la structure d'un tel appareil électronique lui permettant de s'adapter à diverses contraintes thermiques ou d'environnement. Ces appareils sont notamment utilisés dans le domaine des automatismes industriels ou des automatismes du bâtiment.

Suivant les applications envisagées, il existe différents types d'appareils électroniques de commande moteur, comme par exemple les démarreurs progressifs et les variateurs de vitesse. De même, suivant les types de moteurs utilisés, il existe des variateurs de vitesse pour moteurs asynchrones (appelés aussi convertisseur de fréquence), pour moteurs synchrones ou pour moteurs à courant continu. Ces appareils comportent un certain nombre de composants électroniques de puissance, qui dégagent une quantité de chaleur importante qu'il faut impérativement dissiper à l'extérieur de l'appareil.

Habituellement, un appareil de commande moteur se présente dans un boîtier moulé ou vissé muni de borniers pour les raccordements extérieurs de puissance et de contrôle et comportant parfois une interface de dialogue en face avant. Pour dissiper la chaleur, certains appareils sont dotés de radiateurs placés à proximité des composants de puissance et susceptibles de dépasser à l'extérieur du boîtier pour améliorer les échanges thermiques avec l'extérieur. Par ailleurs, le boîtier présente souvent des parois qui sont dotées de fines ouvertures d'aération ainsi qu'un ventilateur pour améliorer la circulation d'air. Un tel boîtier d'un appareil de commande moteur répond alors généralement à un indice de protection IP20, c'est-à-dire qu'il n'y a pas de possibilité d'insertion d'un doigt humain dans les ouvertures du boîtier risquant de toucher des pièces sous tension. De plus, parois du boîtier ne doivent pouvoir se démonter qu'avec l'aide d'un outil et doivent résister à un effort d'arrachement de l'ordre de 6 Kg.

Cependant, dans certaines applications, en particulier quand l'appareil est destiné à être monté dans une enveloppe fermée (comme un coffret ou une armoire), les contraintes thermiques sont telles que les dispositifs décrits ci-dessus ne suffisent pas à refroidir correctement les composants et à éviter des pics de chaleur à l'intérieur de l'appareil. Il est alors nécessaire de déclasser l'appareil en courant ou d'apporter une ventilation supplémentaire à l'enveloppe, ce qui nécessite d'utiliser des coffrets ou armoires non-standards et ce qui pénalise donc globalement le coût de la solution.

Or, lorsqu'il est placé dans une enveloppe fermée, l'appareil n'a pas obligatoirement besoin de répondre à un indice de protection IP20. Un indice IP00, dans lequel le boîtier n'est pas complètement fermé et où un accès aux pièces sous tension est possible, est acceptable puisque l'appareil est déjà installé dans une enceinte fermée. Dans ce cas, il serait donc avantageux de pouvoir enlever certaines parois du boîtier ce qui faciliterait amplement la circulation d'air dans le boîtier, améliorerait le refroidissement et éviterait l'apparition de pics de chaleur ("points chauds") à l'intérieur du boîtier. Cependant, si la structure du boîtier de l'appareil de commande moteur n'est pas conçue dans ce sens, il est difficile d'enlever facilement toutes ou une partie des parois du boîtier sans avoir à réimplanter dans l'enceinte formée certains constituants du boîtier initialement fixés à une de ces parois (à savoir carte puissance, carte contrôle, borniers de raccordement, interface de dialogue, câbles de connexion, etc...). Des adaptations mécaniques sont alors souvent nécessaires et pénalisantes, notamment pour le temps de mise en oeuvre.

Les documents US4908738 et EP0290617 décrivent des appareils de commande moteur comportant un boîtier logeant des composants électroniques de puissance. Ces boîtiers ne sont cependant pas prévus pour pouvoir être facilement modifiables d'une configuration à une autre,

Le but de l'invention est donc de concevoir une solution simple et économique permettant qu'un même appareil de commande moteur puisse s'adapter très rapidement aussi bien à une configuration habituelle fermée de type IP20, qu'à une configuration ouverte de type IP00, en fonction de l'application et du mode d'installation de l'appareil de commande moteur, sans pour autant pénaliser l'encombrement total de l'appareil ni le temps de mise en oeuvre. Cette adaptation doit pouvoir se faire directement au dernier moment par l'utilisateur chargé de réaliser l'installation de l'appareil, un même appareil pouvant alors répondre aux différents besoins.

C'est pourquoi l'invention décrit un appareil de commande d'un moteur électrique comprenant une embase logeant des composants électroniques de puissance, un cadre fixé à l'avant de l'embase, un module contrôle fixé à l'avant du cadre et apte à se connecter à des moyens de dialogue, Le cadre est de forme sensiblement parallélépipédique et comprend au moins deux faces de côté qui présentent des ouvertures susceptibles d'être recouvertes par des éléments de paroi fixés au cadre de manière amovible.

Selon une caractéristique, les éléments amovibles sont réalisés en matériau polycarbonate et le cadre est réalisé en matériau polyamide.

Selon une autre caractéristique, les éléments amovibles sont fixés au cadre par vissage ou clipsage, sont démontable$ à l'aide d'un outil et comportent des ouïes d'aération.

D'autres caractéristiques et avantages vont apparaître dans la description détaillée qui suit en se référant à un mode de réalisation donné à titre d'exemple et représenté parles dessins annexés sur lesquels:
- la figure 1 schématise une vue éclatée simplifiée d'un appareil de commande conforme à l'invention,
- la figure 2 montre l'exemple de la figure 1 avec les éléments de parois montés sur le cadre de l'appareil dans une configuration IP20,
- la figure 3 montre l'exemple de la figure 1 avec les éléments de parois enlevés dans une configuration IP00,
- la figure 4 représente une variante de l'exemple de la figure 1.

De façon connue un appareil de commande d'un moteur électrique, tel qu'un variateur de vitesse pour moteur asynchrone, comporte habituellement une partie puissance et une partie contrôle. La partie puissance est reliée aux conducteurs d'alimentation de puissance du moteur et regroupe notamment les dispositifs de commutation permettant de commander en fréquence et/ou en tension le moteur (composants électroniques de puissance, éléments de protections, éléments de filtrage, ...). La partie contrôle regroupe notamment les moyens de commande des composants de puissance, les moyens de régulation et de calcul, les moyens de dialogue homme-machine et les moyens de communication.

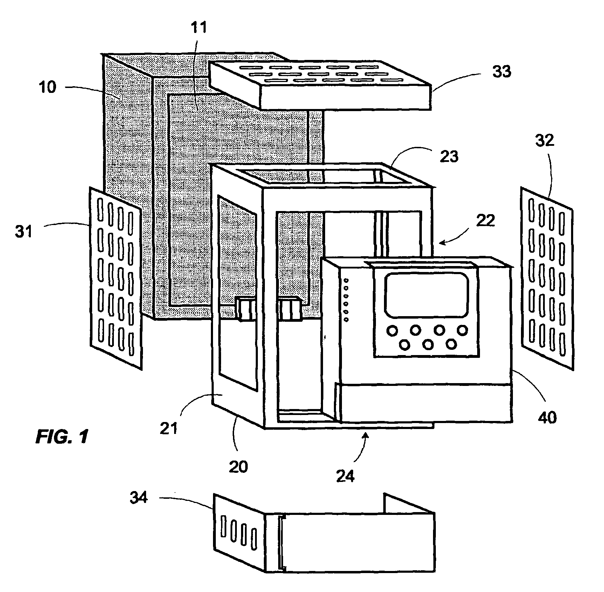

En référence à la figure 1, un appareil de commande de type variateur de vitesse comporte une embase 10, un cadre 20 qui est fixé à l'avant de l'embase 10 et un module contrôle 40 qui est placé à l'avant du cadre 20.

L'embase 10 est de forme sensiblement parallélépipédique et intègre la partie puissance du variateur. L'embase 10 comporte donc au moins une carte électronique 11, sur lequel sont montés des composants électroniques de puissance (non représentés sur les figures pour des raisons de simplification), ainsi qu'un ou plusieurs borniers 12 de puissance et borniers de liaison avec la partie contrôle. L'embase 10 peut comporter également divers constituants habituels pour la dissipation de la chaleur, tels qu'un radiateur, un ventilateur et/ou des ouïes d'aération. Par ailleurs, des moyens de fixation classiques placés à l'arrière de l'embase 10 permettent de fixer l'appareil de commande sur un support quelconque (platine, châssis, cadre d'armoire,...).

Le cadre 20 est un châssis de forme sensiblement parallélépipédique qui comprend une face avant et une face arrière ajourées entre lesquelles sont situées quatre faces de côtés à savoir : deux faces latérales 21,22, une face supérieure 23 et une face inférieure 24. L'intérieur du cadre 20 est essentiellement vide. La face arrière du cadre 20 est positionnée contre l'embase 10 et le module contrôle 40 de l'appareil est fixé contre la face avant du cadre 20.

Le module contrôle intègre la partie contrôle de l'appareil de commande et comporte un boîtier 40 comprenant au moins une carte électronique de contrôle. Cette carte électronique peut se connecter à des moyens de dialogue homme-machine, destinés notamment au paramétrage, à la surveillance et à la visualisation d'états de l'appareil. Ces moyens de dialogue composent par exemple de plusieurs DEL (ou LED) de signalisation 42 visibles sur la face avant du boîtier 40 du module contrôle et montées sur la carte contrôle. Les moyens de dialogue peuvent également comporter une interface de dialogue utilisateur 41 dotée de touches et d'un écran d'affichage. L'interface de dialogue 41 peut se loger de façon amovible dans un emplacement prévu à l'avant du boîtier 40 du module contrôle, afin d'être connectée soit en permanence, soit temporairement au module contrôle. L'interface de dialogue 41 pourrait aussi être séparée du boîtier 40 du modulé contrôle et être raccordée au module contrôle par une connexion de type électrique, optique ou sans fil (wireless).

Le module contrôle peut comporter un ou plusieurs borniers contrôle et un ou plusieurs borniers pour bus de communication, permettant d'effectuer à distance la commande, le paramétrage et/ou la surveillance de l'appareil de commande. Le boîtier 40 du module contrôle peut alors comporter sur sa partie avant une porte 43 pivotable pour faciliter l'accès à ce du ces borniers.

Par ailleurs, le raccordement entre la partie puissance et la partie contrôle de l'appareil de commande s'effectue par des câbles ou des connecteurs qui traversent le cadre 20 et relient la carte électronique 11 au module contrôle 40. De plus, plusieurs options fonctionnelles peuvent être intégrées à l'appareil de commande au moyen d'un ou plusieurs modules options qui sont raccordés au module contrôle et agencés par exemple de façon superposée entre le cadre 20 et le boîtier 40.

Selon l'invention, au moins deux des faces de côté 21,22,23,24 du cadre 20 sont ajourées et présentent des ouvertures ou fenêtres d'aération, respectivement 21',22',23',24', qui facilitent la circulation de l'air dans l'appareil. Ces ouvertures 21',22',23',24' peuvent être recouvertes par des éléments de parois, respectivement 31,32,33,34, qui sont fixés au cadre 20 de manière amovible.

Dans un mode de réalisation simplifié, seulement deux faces de côté du cadre 20 sont ajourées pour l'entrée et la sortie de l'air. Par exemple, seules les faces supérieure 23 et inférieure 24 du cadre 20 sont ajourées et des éléments de parois amovibles supérieur 33 et inférieur 34 recouvrent respectivement les ouvertures 23',24' de ces deux faces 23,24. Dans un autre mode de réalisation, seules les deux faces latérales 21,22 du cadre 20 sont ajourées et des éléments de parois amovibles latéraux 31,32, de préférence identiques, recouvrent respectivement les ouvertures 21', 22' de ces deux faces 21,22. Dans le mode de réalisation préféré qui est présenté dans les figures, toutes les faces de côté (à savoir les deux faces latérales 21,22, la face supérieure 23 et la face inférieure 24) du cadre 20 sont ajourées pour augmenter la circulation de l'air à l'intérieur de l'appareil de commande lorsque les éléments de parois amovibles 31,32,33,34 sont enlevés.

Certains constituants de l'appareil de commande peuvent être fixés directement sur le cadre 20 (comme par exemple les câbles de liaison entre partie puissance et partie contrôle) mais aucun constituant de l'appareil n'est fixé sur un élément de paroi amovible 31,32,33,34.

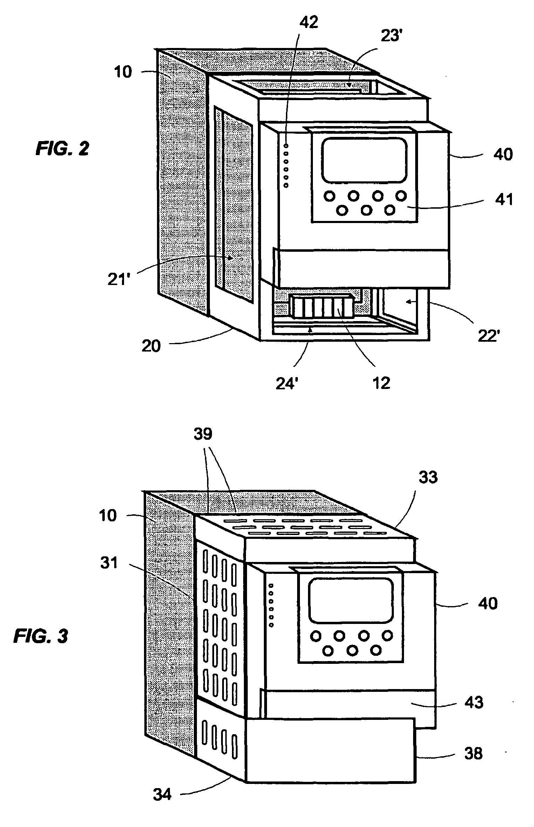

Lorsque les éléments de parois amovibles 31,32,33,34 sont fixés au cadre 20, l'appareil répond alors à un indice de protection IP20 habituel dans ce genre d'appareil. Cette configuration est représentée en figure 3.

Lorsque les éléments de parois sont enlevés (en particulier quand l'appareil est placé dans une enceinte fermée), l'appareil de commande répond seulement à un indice de protection IP00 puisque les ouvertures 21',22',23',24' ne sont pas recouvertes. La circulation de l'air à l'intérieur de l'appareil est alors notablement améliorée ce qui diminue le risque de pics de chaleur dans l'appareil. Cette configuration est représentée en figure 2.

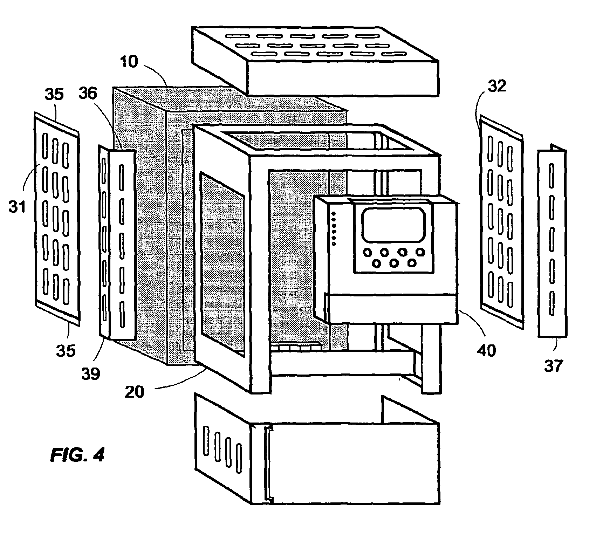

Les différents éléments de parois amovibles sont fixés au cadre 20 indifféremment par vissage ou par ciipsage grâce à des moyens conçus pour une conformité avec l'indicé IP20, Les éléments sont très rapidement démontables, mais uniquement à l'aide d'un outil de façon à éviter tout retrait intempestif par un utilisateur. Alternativement, lorsque les éléments de parois supérieur et inférieur 33,34 recouvrent non seulement les faces 23,34 mais recouvrent aussi légèrement les faces latérales 21,22, on pourrait envisager que les éléments latéraux 31,32 soient simplement maintenus par les éléments 33,34 une fois montés, par exemple grâce à des pattes 35 (indiquées en figure 4) qui viennent se coincer sous les éléments 33,34 une fois montés.

Deux modes d'utilisation (figure 2 / figure 3) sont donc possibles pour un appareil conforme à l'invention, lui permettant avantageusement de s'adapter à différentes contraintes d'environnement. Avantageusement, le passage de l'un à l'autre mode d'utilisation se fait très rapidement et n'entraîne pas d'autres adaptations de l'appareil, puisque aucun constituant de l'appareil n'est fixé sur les éléments amovibles du cadre 20. La mise en oeuvre de l'appareil de commande s'en trouve facilitée.

Les éléments de parois 31,32,33,34 recouvrent soit en totalité, soit en partie seulement le cadre 20. En effet, pour être conforme à l'indice de protection IP20, il suffirait que les éléments amovibles recouvrent seulement la totalité de la surface des ouvertures 21',22',23',24' des faces du cadre 20.

Dans un mode de réalisation préféré, les éléments 31,32,33,34 et le module contrôle 40 recouvrent cependant la totalité du cadre 20 (comme indiqué figure 3). Grâce à cela, comme le cadre 20 est complètement recouvert, il peut alors être réalisé en matériau polyamide (chargé éventuellement en fïbre de verre) qui présente l'avantage d'offrir une meilleure rigidité mécanique qu'un matériau polycarbonate habituel, ce qui diminue notamment sensiblement les problèmes de vibration de l'appareil. Dans ce cas, seules les parties visibles de l'extérieur, c'est-à-dire les éléments de parois 31,32,33,34 et le boîtier 40 du module contrôle sont réalisés en matériau polycarbonate pour garantir une bonne résistance au feu, exigée par les normes (notamment test à la flamme UL50).

Dans les exemples présentés dans les figures, les éléments de paroi supérieur 33 et inférieur 34 recouvrent également partiellement la face avant ainsi que les faces latérales 21,22 du cadre 20. Cette disposition permet notamment de simplifier le recouvrement des arêtes du cadre. Au moins un des éléments amovibles, par exemple l'élément de paroi inférieur 34, comporte des ouvertures permettant le passage extérieur des câbles même en configuration IP20, en particulier les câbles issus du bornier de puissance 12. De plus, l'élément inférieur 34 peut comporter une porte pivotable 38 donnant accès au bornier puissance 12 qui est généralement fixé sur la carte 11 de l'embase 10. Dans un mode de réalisation préféré, l'accès au bornier puissance n'est cependant par direct : la porte pivotable 38 donne par exemple accès à une vis de type ¼ de tour qui permet de démonter l'élément inférieur 34 pour avoir accès au bornier puissance 12.

Le type d'appareil de commande moteur décrit dans l'invention est destiné à couvrir généralement toute une gamme de puissance de moteurs électriques. L'embase 10 contenant la partie puissance de l'appareil possède donc des dimensions très différentes suivant la puissance du moteur à commander, puisque la taille de certains composants de puissance augmente en fonction de la puissance moteur. Par contre, les dimensions du module contrôle 40 ne sont pas forcément impactées par la puissance du moteur, excepté pour de très grosses puissances où une carte d'interface supplémentaire peut être ajoutée,

Ainsi, les exemples des figures 1,2,3 montrent un calibre d'appareil pour lequel la largeur de l'embase 10 et du cadre 20 est à peu près équivalente à la largeur du module 40. Par contre, pour un appareil de commande destiné à un calibre moteur plus important, la largeur et/ou la hauteur du module contrôle 40 peuvent être inférieures à celles du cadre 20 et de l'embase 10 (voir exemple de la figure 4), risquant d'engendrer des ouvertures non protégées sur la face avant du cadre 20 autour du module contrôle 40.

Dans ce cas, pour conserver l'appareil de commande conforme à l'indice IP20, les ouvertures situées au-dessus et au-dessous du module contrôle 40 sont facilement recouvrables en adaptant la taille des éléments supérieur et inférieur 33,34. Pour les ouvertures situées sur les côtés du module contrôle 40, le cadre 20 comporte alors un ou deux éléments de parois frontaux 36,37 verticaux supplémentaires (voir figure 4). Comme les autres éléments de parois, le ou les éléments frontaux 38,37 sont fixés de façon amovible au cadre 20 et peuvent présenter des ouïes d'aération 39. La figure 4 montre un exemple où deux éléments 36,37 sont positionnés respectivement de part et d'autre du boîtier 40 du module contrôle. On pourrait aussi envisager un seul élément frontal 36 ou 37 en fonction de la place du boîtier 40 sur la face avant du cadre 20. De même, on pourrait envisager un seul élément frontal 36 faisant toute la largeur de la face avant du cadre 20 et disposant d'un trou permettant de positionner le boîtier de contrôle 40.

Dans les figures, les quatre éléments de parois 31,32,33,34 sont constitués de quatre pièces distinctes ce qui permet de réaliser des éléments de parois aux formes simples. Dans une variante de invention, une même pièce pourrait aussi regrouper plusieurs éléments adjacents entre eux de façon à diminuer le nombre de pièces à assembler : par exemple une seule pièce formant les éléments amovibles 31,32,33 pour couvrir les ouvertures 21',22',23', ou une seule pièce formant les éléments 31,36, etc....

Il est bien entendu que l'on peut, sans sortir du cadre de l'invention, imaginer d'autres variantes et perfectionnements de détail et de même envisager l'emploi de moyens équivalents,

## Revendications

1. Appareil de commande de moteur électrique, comprenant:
- une embase (10) logeant des composants électroniques de puissance,
- uh cadre (20) fixé à l'avant de l'embase (10),
- un module contrôle (40) fixé à l'avant du cadre (20) et apte à se connecter à des moyens de dialogue (41,42),
**caractérisé en ce que** le cadre (20) est de forme sensiblement parallélépipédique et comprend au moins deux faces de côté (21,22,23,24) qui présentent des ouvertures (21',22',23',24') susceptibles d'être recouvertes par des éléments de paroi (31,32,33,34) fixés au cadre (20) de manière amovible, de telle sorte que, pour améliorer les échanges thermiques, l'appareil de commande peut aisèment passer d'une configuration fermée sans possibilité de toucher des pièces sous tension à une configuration ouverte avec possibilité de toucher lesdites pièces sous tension.

2. Appareil de commande moteur selon la revendication 1, **caractérisé en ce que** le cadre (20) comporte deux faces de côté latérales (21,22) recouvertes par des éléments de paroi latéraux (31,32) fixés au cadre (20) de manière amovible.

3. Appareil de commande moteur selon la revendication 1 ou 2, **caractérisé en ce que** le cadre (20) comporte une face de côté supérieure (23) et une face de côté inférieure (24) recouvertes respectivement par un élément de paroi supérieur (33) et un élément de paroi inférieur (34) fixés au cadre (20) de manière amovible.

4. Appareil de commande moteur selon la revendication 2 ou 3, **caractérisé en ce que** le cadre (20) comprend en outre un ou deux éléments de paroi frontaux (36,37) fixés au cadre (20) de manière amovible.

5. Appareil de commande moteur selon la revendication 3, **caractérisé en ce que** l'élément de paroi inférieur (34) comporte une porte pivotable (38) donnant accès à un bornier puissance (12) fixé à l'embase (10).

6. Appareil de commande moteur selon la revendication 1, **caractérisé en ce que** les éléments amovibles (31,32,33,34) sont réalisés en matériau polycarbonate.

7. Appareil de commande moteur selon la revendication 6, **caractérisé en ce que** le cadre (20) est réalisé en matériau polyamide.

8. Appareil de commande moteur selon la revendication 1, **caractérisé en ce que** les éléments amovibles (31,32,33,34) sont fixés au cadre (20) par vissage ou clipsage et sont démontables à l'aide d'un outil.

9. Appareil de commande moteur selon la revendication 1, **caractérisé en ce que** les éléments amovibles (31,32,33,34) comportent des ouïes d'aération (39).

## Claims

1. Electric motor control appliance, comprising:
- a base (10) housing power electronic components,
- a frame (20) fixed to the front of the base (10),
- a control module (40) fixed to the front of the frame (20) and able to be connected to dialogue means (41, 42),
**characterized in that** the frame (20) is of substantially parallelepipedal form and comprises at least two side faces (21, 22, 23, 24) which present openings (21', 22', 23', 24') which can be covered by wall elements (31, 32, 33, 34) fixed to the frame (20) in a removable way, such that, to enhance the heat exchanges, the control appliance can easily switch from a closed configuration with no possibility of touching live parts to an open configuration with the possibility of touching said live parts.

2. Motor control appliance according to Claim 1, **characterized in that** the frame (20) comprises two lateral side faces (21, 22) covered by lateral wall elements (31, 32) fixed to the frame (20) in a removable way.

3. Motor control appliance according to Claim 1 or 2, **characterized in that** the frame (20) comprises a top side face (23) and a bottom side face (24) respectively covered by a top wall element (33) and a bottom wall element (34) fixed to the frame (20) in a removable way.

4. Motor control appliance according to Claim 2 or 3, **characterized in that** the frame (20) also comprises one or two front wall elements (36, 37) fixed to the frame (20) in a removable way.

5. Motor control appliance according to Claim 3, **characterized in that** the bottom wall element (34) comprises a hinged door (38) giving access to a power terminal block (12) fixed to the base (10).

6. Motor control appliance according to Claim 1, **characterized in that** the removable elements (31, 32, 33, 34) are made of polycarbonate material.

7. Motor control appliance according to Claim 6, **characterized in that** the frame (20) is made of polyamide material.

8. Motor control appliance according to Claim 1, **characterized in that** the removable elements (31, 32, 33, 34) are fixed to the frame (20) by screw fastenings or snap-fit means and can be dismantled using a tool.

9. Motor control appliance according to Claim 1, **characterized in that** the removable elements (31, 32, 33, 34) include ventilation openings (39).

## Patentansprüche

1. Befehlsgerät eines Elektromotors mit:
- einem Unterkasten (10), in dem elektronische Leistungsbauteile untergebracht sind,
- einem Rahmen (20), der vorne am Unterkasten (10) befestigt ist,
- einem Bedienmodul (40), das vorne am Rahmen (20) befestigt ist und sich mit Dialogmitteln (41, 42) verbinden kann,
**dadurch gekennzeichnet, dass** der Rahmen (20) im Wesentlichen parallelepidedförmig ist und mindestens zwei Flächen an der Seite (21, 22, 23, 24) umfasst, die Öffnungen aufweisen (21', 22', 23', 24'), welche durch Wandelemente (31, 32, 33, 34), die lösbar am Rahmen (20) derart befestigt sind , derart abgedeckt werden können, dass zur Verbesserung des Wärmeaustausches das Befehlsgerät leicht von einer geschlossenen Anordnung ohne Möglichkeit, spannungsführende Teile zu berühren, auf eine offene Anordnung mit Möglichkeit, die spannungsführenden Teile zu berühren, wechseln kann.

2. Befehlsgerät eines Motors nach Anspruch 1, **dadurch gekennzeichnet, dass** der Rahmen (20) zwei seitliche Flächen an der Seite (21, 22) umfasst, die durch seitliche Wandelemente (31, 32) abgedeckt sind, welche lösbar am Rahmen (20) befestigt sind.

3. Befehlsgerät eines Motors nach Anspruch 1 oder 2, **dadurch gekennzeichnet, dass** der Rahmen (20) eine obere Fläche an der Seite (23) und eine untere Fläche an der Seite (24) umfasst, die jeweils durch ein oberes Wandelement (33) und ein unteres Wandelement (34) abgedeckt sind, welche lösbar am Rahmen (20) befestigt sind.

4. Befehlsgerät eines Motors nach Anspruch 2 oder 3, **dadurch gekennzeichnet, dass** der Rahmen (20) ferner ein oder zwei Frontwandelemente (36, 37) umfasst, die lösbar am Rahmen (20) befestigt sind.

5. Befehlsgerät eines Motors nach Anspruch 3, **dadurch gekennzeichnet, dass** das untere Wandelement (34) eine drehbare Tür (38) für den Zugang auf einen Leistungsanschlussblock (12), der am Unterkasten (10) befestigt ist, umfasst.

6. Befehlsgerät eines Motors nach Anspruch 1, **dadurch gekennzeichnet, dass** die lösbaren Elemente (31, 32, 33, 34) aus Polycarbonatmaterial ausgeführt sind

7. Befehlsgerät eines Motors nach Anspruch 6, **dadurch gekennzeichnet, dass** der Rahmen (20) aus Polyamidmaterial ausgeführt ist.

8. Befehlsgerät eines Motors nach Anspruch 1, **dadurch gekennzeichnet, dass** die lösbaren Elemente (31, 32, 33, 34) am Rahmen (20) durch Verschraubung oder Verklipsung befestigt sind und mittels eines Werkzeugs ausgebaut werden können.

9. Befehlsgerät eines Motors nach Anspruch 1, **dadurch gekennzeichnet, dass** die lösbaren Elemente (31, 32, 33, 34) Lüftungsschlitze (39) umfassen.
